(19) Europäisches Patentamt
European Patent Office
Office européen des brevets

(11) Veröffentlichungsnummer: **0 022 081**
**B1**

(12) # EUROPÄISCHE PATENTSCHRIFT

(45) Veröffentlichungstag der Patentschrift: **09.02.83**

(21) Anmeldenummer: **80810203.2**

(22) Anmeldetag: **17.06.80**

(51) Int. Cl.³: **C 08 K 5/41,** C 08 F 2/50 // G03C1/68, G03F7/00, (C08F2/50, C08G59/68)

(54) **Sulphoxoniumsalze enthaltende polymerisierbare Mischungen sowie Verfahren zur Herstellung hochmolekularer Produkte aus diesen Mischungen durch Bestrahlung.**

(30) Priorität: **19.06.79 GB 7921380**
**27.02.80 GB 8006626**

(43) Veröffentlichungstag der Anmeldung: **07.01.81 Patentblatt 81/1**

(45) Bekanntmachung des Hinweises auf die Patenterteilung: **09.02.83 Patentblatt 83/6**

(84) Benannte Vertragsstaaten: **BE CH DE FR GB IT LI NL SE**

(56) Entgegenhaltungen:
**GB-A-1 516 511**
**GB-A-1 535 492**

(73) Patentinhaber: **CIBA-GEIGY AG, Patentabteilung Postfach, CH-4002 Basel (CH)**

(72) Erfinder: **Green, George Edward, Dr., 18 Church Street, Stapleford Cambridge CB2 5DS (GB)**
Erfinder: **Irving, Edward, Dr., 41, Swaffham Road, Burwell Cambridge CB5 0AN (GB)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**EP 0 022 081 B1**

BUNDESDRUCKEREI BERLIN

# Sulphoxoniumsalze enthaltende polymerisierbare Mischungen sowie Verfahren zur Herstellung hochmolekularer Produkte aus diesen Mischungen durch Bestrahlung

Die vorliegende Erfindung betrifft härtbare Mischungen, enthaltend polymerisierbare Verbindungen und ein Aryloxysulphoxoniumsalz, die Polymerisation solcher Mischungen mittels aktinischen Strahlen und/oder Hitze und die Verwendung solcher Mischungen für Oberflächenbeschichtungen, für die Herstellung von Druckplatten, gedruckten Schaltungen oder verstärkten Verbandstoffen und als Klebstoffe.

Aus vielen Gründen wurde es wünschenswert, die Polymerisation von organischen Verbindungen durch aktinische Strahlen zu induzieren. Die Anwendung von Photopolymerisationsverfahren kann die Verwendung von organischen Lösungsmitteln erübrigen und die damit verbundene Gefahr der Toxizität, Entflammbarkeit, Verschmutzung sowie der Kosten für die Rückgewinnung des Lösungsmittels. Die Photopolymerisation ermöglicht es ferner, die Härtung des Harzes auf bestimmte Teile bzw. Zonen zu beschränken, d. h., auf welche, die bestrahlt wurden, und erlaubt somit die Herstellung von gedruckten Schaltungen, Druckplatten sowie das Verkleben von Substraten an bestimmten Stellen.

Es ist aus der GB-PS 1 321 263 bekannt, daß bestimmte aromatische Diazoniumsalze bei Bestrahlung mit aktinischen Strahlen sich zersetzen und daß, wenn diese Salze mit kationisch polymerisierbaren Substanzen gemischt werden, die dann bei der Bestrahlung entstehende Levissäure die Polymerisation induziert. Doch befriedigen die Diazoniumsalze nicht in jeder Hinsicht. Die Lagerstabilität der aus Diazoniumsalz und kationisch polymerisierbaren Substanzen bestehenden Mischungen ist oft zu kurz, besonders bei Tageslicht und zweitens entsteht bei der Freisetzung der Lewissäure Stickstoff, und die Gasbildung schränkt die Anwendung dieser Katalysatoren für den Härtungsprozeß ein.

Viele Verbesserungen wurden daher vorgeschlagen bezüglich des Ersatzes dieser Diazoniumsalze durch andere Katalysatoren für die Strahlungshärtung, wobei keine Gasbildung auftritt, zum Beispiel die Verwendung von Oniumsalzen des Schwefels, ferner Jodoniumsalze.

So wird in der GB-PS 1 516 511 offenbart, daß Mono-1,2-epoxide und Epoxidharze mit durchschnittlich mehr als einer 1,2-Epoxidgruppe im Molekül in Gegenwart von strahlungsempfindlichen aromatischen Oniumsalzen des Sauerstoffs, Schwefels, Selens oder Tellurs polymerisiert bzw. gehärtet werden können, wenn auf diese Mischungen eine Strahlungsenergie einwirkt, wobei eine Brönsted-Säure, die als Katalysator wirkt, freigesetzt wird. Die einzigen Salze, die in der GB-PS beschrieben werden, entsprechen der Formel I

$$[(R)_a(R^1)_b(R^2)_cX]_d^+[MQ_e]^{(e-f)-} \qquad (I)$$

worin

- R eine einwertige aromatische Gruppe,
- R¹ ein Alkyl, Cycloalkyl oder ein substituiertes Alkyl,
- R² einen mehrwertigen aliphatischen oder aromatischen Rest, der eine heterocyclische oder kondensierte Ringstruktur bildet, bedeuten,
- X für Sauerstoff, Schwefel, Selen oder Tellur steht,
- M ein Metall oder Nichtmetall, wie Antimon, Eisen, Zinn, Wismut, Aluminium, Gallium, Indium, Titan, Zirkonium, Scandium, Vanadin, Chrom, Mangan, Bor, Phosphor oder Arsen, bedeutet,
- Q ein Halogenatom bedeutet,
- a für Null oder 1, 2 oder 3 steht,
- b für Null, 1 oder 2 steht,
- c für Null oder 1 steht, wobei die Summe aus a + b + c drei oder der Wertigkeit von X entspricht,
- d die Bedeutung (e – f) hat,
- f die Wertigkeit von M ist und eine Zahl von 2 bis 7 darstellt und
- e größer als f ist und eine Zahl bis 8 darstellen kann.

In der späteren GB-PS 1 518 141 wird dann ferner offenbart, daß die Oniumsalze der obigen Formel I auch als Katalysatoren für kationisch polymerisierbare Verbindungen, die frei von 1,2-Epoxidgruppen sind, eingesetzt werden können. Als solche Verbindungen werden Vinylmonomere, Vinylprepolymere, cyclische Äther, cyclische Ester, cyclische Sulfide, cyclische Amine und cyclische Organosilikone genannt, welche in Gegenwart der Oniumsalze unter Einwirkung von Strahlungsenergie polymerisieren.

In der US-PS 4 102 687 wird dann weiterhin offenbart, daß auch Harnstoff-, Melamin- und Phenol-Formaldehydharze in Gegenwart der Oniumsalze der Formel I mittels UV-Strahlen, angehärtet und durch nachfolgendes Erhitzen vollständig ausgehärtet werden können.

In der GB-PS 1 535 492 wird die Verwendung von strahlungsempfindlichen Sulfoniumsalzen der Arylsulfonsäure, Halogenarylsulfonsäure, Alkylsulfonsäure und Halogenalkylsulfonsäure für die kationische Polymerisation von Epoxidharzen, Vinylmonomeren und -präpolymeren, organischen

cyclischen Äthern und Estern, organischen, cyclischen Sulfiden, cyclischen Aminen und organischen cyclischen Silikonen.

In der US-PS 4 139 385 wird die Verwendung von Sulfoniumsalze für die Härtung von Polyolefinen mittels Polythiolen beschrieben. Eine äthylenisch ungesättigte Verbindung, wie Diallylphthalat, Diallylmaleinat, Triallylcyanurat wird mit einem Polythiol, wie Trimethylolpropantrithioglycollat oder Pentaerythrittetra-(3-mercaptopropionat), und beispielsweise Triphenylsulphoniumhexafluoroarsenat oder Tetrafluoroborat gemischt und dann mit UV-Licht bestrahlt. Die als Salze verwendeten Katalysatoren entsprechen der Formel II, III oder IV

$$[(R)_a(R^1)_bI]^+[MX_k]^{(k-m)-} \qquad (II)$$

$$[(R)_c(R^2)_eS]^+[MX_k]^{(K-m)-} \qquad (III)$$

$$[(R)_f(R^4)_g(R^5)_hZ]^+[MX_k]^{(k-m)-} \qquad (IV)$$

worin

R eine einwertige aromatische Gruppe,
$R^1$ ein zweiwertiger aromatischer Rest,
$R^2$ ein mehrwertiger aliphatischer oder aromatischer Rest, der eine heterocyclische oder kondensierte Ringstruktur bildet,
$R^4$ ein Alkyl, Alkoxy, Cycloalkyl oder substituiertes Alkyl,
$R^5$ ein mehrwertiger Rest, der eine aromatische, heterocyclische oder kondensierte Ringstruktur bildet,
M ein Atom eines Metalls oder Nichtmetalls,
X ein Halogenatom,
Z ein Stickstoff-, Phosphor-, Arsen-, Wismut- oder Antimonatom bedeuten,
a für Null oder 2,
b für Null oder 1, wobei a + b gleich 2 oder der Wertigkeit von Jod,
c für Null oder 3,
d für Nul! oder 2,
e für 0 oder 1, wobei die Summe aus c + d + e gleich 3 oder der Wertigkeit von Schwefel entspricht,
f für eine Zahl von Null bis 4,
g für Null, 1 oder 2,
h für Null, 1 oder 2, wobei die Summe aus f + g + h gleich 4 oder der Wertigkeit von Z entspricht, stehen
j die Bedeutung (k – m) hat,
m der Wertigkeit von M entspricht und
k eine ganze Zahl von größer als 1 und nicht größer als 8 bedeutet.

In der DE-OS 2 833 648 wird offenbart, daß Triarylsulfoniumsalze der Formel V

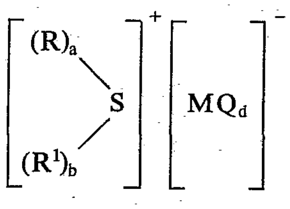

(V)

als Initiatoren für die Strahlungshärtung von olefinisch ungesättigten Verbindungen, welche eine 1,2-Epoxidgruppe enthalten, wie Glycidylacrylat, oder Mischungen aus einem Epoxidharz und einer olefinisch ungesättigten Verbindung, wie Methacrylat, Polyester oder Styrol, geeignet sind. In der Formel V bedeuten

R einen gegebenenfalls substituierten heterocyclischen oder aromatischen Rest mit 6 bis 13 C-Atomen,
$R^1$ einen zweiwertigen aromatischen oder heterocyclischen Rest, der gegebenenfalls substituiert sein kann,
a gleich 1 oder 3,
b gleich Null oder 1,
S die Wertigkeit von 3,
M ein Metall- oder ein Nichtmetallatom,
Q ein Halogenatom und
d eine Zahl von 4 bis 6.

Sowohl die in der DE-OS 2 730 725 als auch im US-Patent 4 081 276 eingesetzten Oniumsalze des Schwefels entsprechen den zuvor genannten Oniumsalzen der Formel I.

Auch die im US-Patent 4 090 936 offenbarten photohärtbaren Mischungen aus Epoxidharzen und olefinisch ungesättigten Verbindungen enthalten als Photoinitiator die bereits genannten Sulphoniumsalze.

In der US-PS 4 069 054 werden photopolymerisierbare Mischungen offenbart, die neben dem kationisch polymerisierbaren Monomer und einer aromatischen Sulfoniumverbindung noch ein aromatisches tertiäres Amin, ein aromatisches tertiäres Diamin oder eine aromatische polycyclische Verbindung als Photosensibilisator enthalten.

Es wurde nun gefunden, daß kationisch polymerisierbare Verbindungen in Gegenwart von Aryloxysulphoxoniumsalzen photopolymerisiert werden können, wobei im Vergleich zur bekannten Verwendung von Sulfonium- oder Jodoniumsalzen die Photopolymerisation schneller abläuft. Entgegen der in der US-PS 4 102 687 offenbarten Lehre können Harnstoff-Formaldehydharze in Gegenwart der Aryloxysulphoxoniumsalze sowohl durch aktinische Bestrahlung allein als auch Erhitzen vollständig ausgehärtet werden.

Die erfindungsgemäße Verwendung der Aryloxysulphoxoniumsalze bieten gegenüber der bekannten Verwendung von Sulfoniumsalzen noch den Vorteil, daß bei der Bestrahlung kein unangenehmer Geruch nach Schwefelwasserstoff auftritt.

Die vorliegende Erfindung betrifft somit Mischungen, enthaltend

a) eine Verbindung oder Mischungen von Verbindungen, welche unter dem Einfluß von kationischen Katalysatoren in höhermolekulare Produkte umwandelbar sind und
b) eine wirksame Menge eines Aryloxysulphoxoniumsalzes der Formel VI

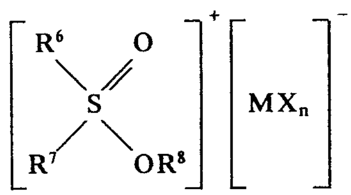

(VI)

worin

$R^6$ und $R^7$ je ein unsubstituiertes oder gegebenenfalls durch ein oder zwei Halogenatome substituiertes oder durch ein Äthersauerstoffatom oder eine Sulfonylgruppe unterbrochenes Alkyl mit 1 bis 6 C-Atomen, ein Aryl mit 6 bis 15 C-Atomen, eine Alkoxygruppe mit 6 bis 15 C-Atomen oder $R^6$ und $R^7$ zusammen einen zweiwertigen Rest mit 4 bis 10 C-Atomen bedeuten,
$R^8$ ein Aryl mit 6 bis 15 C-Atomen bedeutet,
M für ein Metall- oder Nichtmetallatom steht,
X ein Halogenatom, vorzugsweise Fluor- oder Chloratom, bedeutet, und
n für die Zahl 4, 5 oder 6 steht, wobei diese Zahl um eins größer ist, als die Wertigkeit von M beträgt.

Gegenstand der vorliegenden Erfindung ist auch das Verfahren zur Herstellung von höhermolekularen Produkten aus einer Verbindung oder Mischungen von Verbindungen, die unter dem Einfluß von kationischen Katalysatoren in höhermolekulare Produkte umwandelbar sind, indem man Mischungen aus solchen Verbindungen und Katalysatoren der aktinischen Bestrahlung aussetzt.

Es wurde ferner gefunden, daß kationisch polymerisierbare Verbindungen auch durch Erhitzen der kationische Katalysatoren enthaltenden Mischungen polymerisiert werden können.

Die vorliegende Erfindung betrifft somit auch das Verfahren zur Herstellung von höhermolekularen Produkten aus Verbindungen, die unter dem Einfluß von kationischen Katalysatoren in höhermolekulare Produkte umwandelbar sind, indem man Mischungen aus solchen Verbindungen und kationischen Katalysatoren erhitzt.

Vorzugsweise bedeuten in der Formel VI $R^6$ und $R^7$ je ein Aryl oder Aryloxy mit 6 bis 11 C-Atomen oder zusammen ein Alkylen. Insbesondere bedeutet $R^6$ ein unsubstituiertes oder gegebenenfalls durch ein oder zwei Alkyle mit 1 bis 4 C-Atomen oder durch ein oder zwei Fluor-, Chlor- oder Bromatome substituiertes Phenyl oder Naphthyl. Und $R^7$ bedeutet insbesondere ein unsubstituiertes oder gegebenenfalls durch ein oder zwei Alkyle mit 1 bis 4 C-Atomen oder durch ein oder zwei Fluor-, Chlor- oder Bromatome substituiertes Phenyl, Phenoxy, Naphthyl oder Naphthyloxy. Wenn $R^6$ und $R^7$ zusammen ein Alkylen bedeuten, stehen diese insbesondere für den Rest $(-CH_2-)_4$.

$R^8$ bedeutet insbesondere ein unsubstituiertes oder gegebenenfalls durch ein oder zwei Alkyle oder Alkoxy mit 1 bis 4 C-Atomen, ein oder zwei Nitrogruppen, Fluor-, Chlor- oder Bromatome substituiertes Phenyl oder Naphthyl.

M bedeutet vorzugsweise ein Bor-, Phosphor-, Arsen-, Antimon- oder Wismutatom, insbesondere ein Bor- oder Phosphoratom.

Das Anion $MX_n^-$ kann beispielsweise Hexachlorwismutat sein, ist aber vorzugsweise Hexafluoroantimonat, Hexafluoroarsenat, Hexafluorophosphat oder Tetrafluoroborat.

Als spezifische Beispiele für geeignete Sulphoxoniumsalze seien genannt:

Diphenylphenoxysulphoxoniumhexafluorophosphat,
Phenyldiphenoxysulphoxoniumhexafluorophosphat,
Methyldiphenoxysulphoxoniumhexafluorophosphat,
p-Tolylphenoxy-p-tolyloxysulphoxoniumhexafluorophosphat,
Äthyl-(äthylsulphonylmethyl)-p-tolyloxysulphoxoniumhexafluorophosphat,
p-Chlorophenoxy-p-tolylphenoxysulphoxoniumhexafluorophosphat,
1-Phenoxy-1-oxidotetrahydrothiopheniumhexafluorophosphat,
1-Phenoxy-1-oxidotetrahydrothiopheniumtetrafluoroborat und
1-Phenoxy-1-oxidotetrahydrothiopheniumhexafluoroantimonat.

Die Salze der Formel sind allgemein bekannt und können nach dem in »J. Chem. Soc. (C)«, 1970, Seite 682-6, beschriebenen Verfahren durch Zersetzung der entsprechenden Aryldiazoniumsalze der Formel VII

$$R^8N_2^+MX_n^- \qquad (VII)$$

in Gegenwart eines Überschusses des geeigneten Sulfon- oder Arylesters einer Alkansulfonsäure oder Arylsulfonsäure der Formel VIII

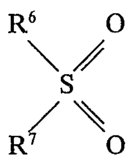

(VIII)

worin $R^6$, $R^7$, $R^8$, M, X und n die zwar genannte Bedeutung haben, wie beispielsweise Dimethylsulphon, Tetrahydrothiophen-1,1-dioxide, Phenylmethanesulphonat oder Phenylbenzolsulphonat.

Die für die Komponente b) angewendete Menge muß ausreichend sein, damit die Polymerisation der Komponente a) beim Bestrahlen mit aktinischen Strahlen oder beim Erhitzen anläuft. Gewöhnlich verwendet man 0,1 bis 7,5, vorzugsweise 0,5 bis 6 Gewichtsteile der Komponente b) pro 100 Gewichtsteile der Komponente a).

Die Komponente a) ist vorzugsweise ein 1,2-Epoxid, ein Vinyl-Monomer oder -Präpolymer, ein Aminoplast oder Phenoplast. Sie kann beispielsweise ein Mono-1,2-epoxid sein, wie Epichlorhydrin, Propylenoxid oder ein Glycidyläther eines einwertigen Alkohols oder Phenols, wie n-Butylglycidyläther der Phenylglycidyläther; oder sie kann ein Glycidylester sein, wie Glycidylacrylat oder Methacrylat.

Vorzugsweise verwendet man ein Epoxidharz, insbesondere solche, die wenigstens eine direkt an ein Sauerstoffatom gebundene Gruppe der Formel IX

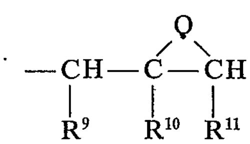

(IX)

aufweisen, worin $R^9$ und $R^{11}$ entweder je ein Wasserstoffatom darstellen, in welchem Fall $R^{10}$ ein Wasserstoffatom oder Methyl bedeutet, oder worin $R^9$ und $R^{11}$ zusammen den Rest $-CH_2-CH_2-$ bedeuten, in diesem Fall $R^{10}$ ein Wasserstoffatom bedeutet.

Als Beispiele für solche Harze seien die Polyglycidyl- und Poly-($\beta$-methylglycidyl-ester genannt, erhältlich durch Umsetzung von Verbindungen mit zwei oder mehreren Carboxylgruppen pro Molekül mit Epichlorhydrin, Glycerindichlorhydrin, oder $\beta$-Methylepichlorhydrin in Gegenwart von Alkali. Solche Polyglycidylester können sich von aliphatischen Polycarbonsäuren ableiten, wie Bernsteinsäure, Glutarsäure, Adipinsäure, Pimelinsäure, Suberinsäure, Azelainsäure, Sebazinsäure, oder dimerisierte oder trimerisierte Linoleinsäure, von cycloaliphatischen Polycarbonsäuren, wie Tetrahydrophthalsäure, 4-Methyltetrahydrophthalsäure, Hexahydrophthalsäure und 4-Methylhexahydrophthalsäure, und von aromatischen Polycarbonsäuren, wie Phthalsäure, Isophthalsäure und Terephthalsäure. Andere geeignete Polycarbonsäureester sind durch Vinylpolymerisation von Glycidylestern vinylischer Säuren, insbesondere von Glycidylacrylat und Glycidylmethacrylat.

Weitere Beispiele für Epoxidharze sind Polyglycidyl- und Poly-($\beta$-methylglycidyl)-äther, die durch Umsetzung einer Verbindung mit wenigstens zwei freien alkoholischen und/oder phenolischen Hydroxylgruppen per Molekül mit einem geeigneten Epihalogenhydrin unter alkalischen Bedingungen oder in Gegenwart eines sauren Katalysators und anschließender Behandlung mit Alkali. Diese Äther können sich ableiten von acyclischen Alkoholen, wie Äthylenglykol, Diäthylenglykol, höhere

Poly-(oxyäthylene)-glykole, Propan-1,2-diol und Poly-(oxypropylen)-glykole, Propan-1,3-diol, Poly-(oxytetramethylen)-glykole, Pentan-1,5-diol, Hexan-2,4,6-triol, Glycerin, 1,1,1-Trimethylolpropan, Pentaerythrit, Sorbit und Poly-(epichlorhydrin), von cycloaliphatischen Alkoholen, wie Resorcit, Chinit, Bis-(4-hydroxycyclohexyl)methan, 2,2-Bis-(4-hydroxycyclohexyl)propan und 1,1-Bis-(hydroxymethyl)-cyclohex-3-en; oder von einem aromatischen Kern enthaltenden Alkoholen, wie N,N-Bis-(2-hydroxyäthyl)-anilin und p,p'-Bis-(2-hydroxyäthylamino)-diphenylmethan. Weitere Diglycidyläther sind die von einkernigen Phenolen, wie Resorcin oder Hydrochinon oder von mehrkernigen Phenolen, wie Bis-(4-hydroxyphenyl)-methan, 4,4-Dihydrodiphenyl, Bis-(4-hydroxyphenyl)-sulfon, 1,1,2,2-Tetrakis-(4-hydroxyphenyl)-äthan, 2,2-Bis-(4-hydroxyphenyl)propan (Bisphenol A), 2,2-Bis-(3,5-dibrom-4-hydroxyphenyl)-propan oder Novolake, hergestellt aus Aldehyden wie Formaldehyd, Acetaldehyd, Chloral oder Furfuraldehyd mit Phenol selbst oder mit am Ring durch Chloratome oder Alkyle mit bis zu 9 C-Atomen substituiertes Phenol, wie 4-Chlorphenol, 2-Methylphenol oder 4-tert.-Butylphenol.

Poly-(N-glycidyl)-Verbindungen können ebenfalls verwendet werden, wie zum Beispiel N-Glycidylderivate von Aminen, wie Anilin, n-Butylamin, Bis-(4-aminophenyl)-methan, und Bis-(4-methylaminophenyl)-methan, ferner Triglycidylisocyanurat, N,N'-Diglycidylderivate von cyclischen Alkylenharnstoffen, wie Äthylenharnstoff oder 1,3-Propylenharnstoff, oder von Hydantonien, wie 5,5-Dimethylhydantoin. Im allgemeinen werden diese nicht bevorzugt eingesetzt.

Poly-(S-glycidyl)-Verbindungen können ebenfalls verwendet werden, wie beispielsweise Di-(S-glycidyl)-derivate von Dithiolen, wie Äthan-1,2-dithiol und Bis-(4-mercaptomethylphenyl)-äther, doch sind diese auch keine bevorzugten Verbindungen.

Beispiele für Epoxidharze mit Gruppierungen der Formel IX, worin $R^9$ und $R^{11}$ zusammen den Äthylenrest darstellen, sind Bis-(2,3-epoxycyclopentyl)-äther, 2,3-Epoxycyclopentylglycidyläther und 1,2-Bis-(2,3-epoxycyclopentyloxy)äthan.

Epoxidharze mit an verschiedenen Heteroatomen gebundenen 1,2-Epoxidgruppen können ebenfalls angewendet werden, wie der Glycidyläther-glycidylester der Salicylsäure.

Auch können Epoxidharze eingesetzt werden, in denen die Epoxidgruppen keine terminierten Gruppen darstellen, wie

Vinylcyclohexendioxid, Limonendioxid, Dicyclopentadiendioxid,
4-Oxatetracyclo[6.2.1.$0^{2,7}$.$0^{3,5}$]undec-9-ylglycidyläther,
1,2-Bis-(4-oxatetracyclo[6.2.1.$0^{2,7}$.$0^{3,5}$]undec-9-yloxy)äthan,
3,4-Epoxycyclohexylmethyl-3',4'-epoxycyclohexancarboxylat und sein
6,6'-Dimethyl-derivat,
Äthylenglykol-bis-(3,4-epoxycyclohexancarboxylat),
3-(3,4-Epoxycyclohexyl)-8,9-epoxy-2,4-dioxaspiro[5,5]undecan

und epoxidierte Butadiene oder Copolymere von Butadien mit äthylenisch ungesättigten Verbindungen, wie Styrol oder Vinylacetat.

Gewünschtenfalls können auch Mischungen von Epoxidharzen eingesetzt werden.

Als besonders bevorzugte Epoxidharze werden die Diglycidyläther, welche auch vorverlängert sein können, von zweiwertigen Phenolen eingesetzt, wie 2,2-Bis-(4-hydroxyphenyl)-propan oder Bis-(4-hydroxyphenyl)-methan und von zweiwertigen aliphatischen Alkoholen, wie Butan-1,4-diol.

Gewünschtenfalls können die Epoxidharze mit mehrwertigen Alkoholen, das heißt Verbindungen mit wenigstens zwei alkoholischen Hydroxylgruppen, vorzugsweise primären, pro Molekül, mitgehärtet werden. Vorzugsweise setzt man den mehrwertigen Alkohol dafür in Mengen von 0,5 bis 1,5 insbesondere 0,75 bis 1,25, alkoholischen Hydroxylgruppen pro 1,2-Epoxidgruppe ein. Vorzugsweise enthält der mehrwertige Alkohol neben den alkoholischen Hydroxylgruppen nur Kohlenstoff- und Wasserstoffatome, gegebenenfalls noch Äthersauerstoffatome, Acetal- oder Carbonyloxygruppen und Halogenatome. Weiterhin weist der Alkohol ein Molekulargewicht von mindestens 100, insbesondere mehr als 1000 auf. Beispiele für mehrwertige Alkohole sind Poly-(oxyäthylen)glykole, Poly-(oxypropylen)-glykole, Poly-(oxytetramethylen)-glykole, Polyepichlorhydrine, Poly-(oxyäthylen)-, Poly-(oxypropylen)- und Poly-(oxytetramethylen)-triole, erhältlich durch Polymerisation von Äthylenoxid, Propylenoxid oder Tetrahydrofuran in Gegenwart von Glycerin oder 1,1,1-Trimethylolpropan, Hydroxyl-terminierten Polycaprolactonen, Copolymeren von Styrol mit Allylalkohol, Polyvinylalkoholen, Hydroxypropylcellulose, Hydroxygruppen aufweisenden Polyvinylacetalen und Teilester der Cellulose, zum Beispiel Celluloseacetatbutyrate.

Vinyl-Monomere und -Präpolymere, welche polymerisiert werden können sind beispielsweise Styrol, $\alpha$-Methylstyrol, Allylbenzol, Divinylbenzol, Vinylcyclohexan, 4-Vinylcyclohex-1-en, N-Vinylpyrrolidin-2-on, N-Vinylcarbazol, Acrolein, Isopren, Butadien, Piperylen, Vinylacetat und Vinyläthers, wie Isobutylvinyläther, Methylvinyläther, Trimethylolpropantrivinyläther, Glycerintrivinyläther, Vinyläther von Äthylenglykol und Poly(oxyäthylenglykolen) und cyclische Vinyläther mit wenigstens zwei cyclischen Vinyläthergruppen, wobei jede einen Teil des 3,4-Dihydro-2H-pyrankernes darstellt, wie zum Beispiel 3,4-Dihydro-2H-pyran-2-ylmethyl-3,4-dihydro-2H-pyran-2-carboxylat und seine Präpolymeren. Die bevorzugten Vinylverbindungen sind Vinyläther von aliphatischen einwertigen Alkoholen und 3,4-Dihydro-2H-pyran-2-ylmethyl-3,4-dihydro-2H-pyran-2-carboxylat und seine Präpolymeren.

Als Aminoplaste für die Komponente a) werden bevorzugt solche eingesetzt, welche mindestens zwei Gruppen der Formel $-CH_2OR^{12}$ an ein amidisches oder thioamidisches N-Atom gebunden

enthalten, wobei $R^{12}$ ein Wasserstoffatom, ein Alkyl mit 1 bis 4 C-Atomen oder ein Acetyl bedeutet. Beispiele für solche Aminoplasten sind die N-Hydroxymethyl-, N-Methoxymethyl-, N-Butoxymethyl- und N-Acetoxymethyl-Derivate der folgenden Amide und amidähnlichen Substanzen:

1. Harnstoff, Thioharnstoff und die cyclischen Harnstoffe der Formel X

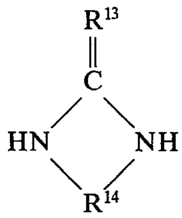

worin $R^{13}$ für ein Sauerstoff- oder Schwefelatom steht und $R^{14}$ einen Rest der Formel XI

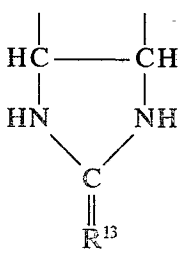

(XI)

oder einen divalenten Rest mit 2 bis 4 C-Atomen bedeutet, der gegebenenfalls durch Methyl, Methoxy oder Hydroxy substituiert oder durch —CO—, —O—, or —N($R^{15}$)— unterbrochen sein kann, wobei $R^{15}$ ein Alkyl Hydroxyalkyl Hydroxylalkyl mit bis zu 4 C-Atomen bedeutet.
Beispiele für solche cyclischen Harnstoffe sind Äthylenharnstoff (Imidazolidin-2-on), Dihydroxyäthylenharnstoff (4,5-Dihydroxyimidazolidin-2-on), Hydantoin, Uron (Tetrahydrooxadiazin-4-on), 1,2-Propylenharnstoff (4-Methylimidazolidin-2-on), 1,3-Propylenharnstoff (Hexahydro-2H-pyrimid-2-on), Hydroxypropylenharnstoff (5-Hydroxyhexahydro-2H-pyrimid-2-on), Dimethylpropylenharnstoff (5,5-Dimethylhexahydro-2H-pyrimid-2-on), Dimethylhydroxypropylenharnstoff und Dimethylmethoxy-propylenharnstoff (4-Hydroxy- und 4-Methoxy-5,5-dimethylhexahydro-2H-pyrimid-2-on), 2-Äthyltriazin-2-on und 5-(2-Hydroxyäthyl)-triazin-2-on.
2. Carbaminate und Dicarbaminate von aliphatischen Mono- und Diolen, die bis zu 4 C-Atome enthalten, wie beispielsweise Methyl-, Äthyl-, isopropyl-, 2-Hydroxyäthyl-, 2-Methoxyäthyl-, 2-Hydroxy-n-propyl- und 3-Hydroxy-n-propylcarbaminat sowie Äthylen- und 1,4-Butylendicarbaminat.
3. Melamin und andere Polyamino-1,3-triazine wie Acetoguanamin, Benzoguanamin und Adipoguanamin.

Gewünschtenfalls können auch solche Aminoplasten verwendet werden, die sowohl eine N-Hydroxymethyl- und ein N-Alkoxymethyl- als auch eine N-Hydroxymethyl- und eine N-Acetoxymethylgruppe enthalten.

Die bevorzugten Aminoplasten sind Kondensationsprodukte von Harnstoff, Uron, Hydantoin oder Melamin mit Formaldehyd und die zum Teil oder vollständig Produkte dieser Kondensationsprodukte mit aliphatischen einwertigen Alkoholen, die 1 bis 4 C-Atome enthalten.

Die bevorzugt verwendeten Phenoplasten sind Resole aus Phenol und einem Aldehyd. Geeignete Phenole sind beispielsweise Phenol, Resorcin, 2,2-Bis-(p-hydroxyphenyl)-propan, p-Chlorphenol, ein durch ein oder zwei Alkyle substituiertes Phenol, wobei jedes Alkyl 1 bis 9 C-Atome enthält, wie beispielsweise o- und p-Kresol, Xylenole, p-tert.-Butylphenol, p-Nonylphenol und phenylsubstituierte Phenole, insbesondere p-Phenylphenol. Der mit Phenol kondensierte Aldehyd ist vorzugsweise Formaldehyd, doch können auch andere Aldehyde, wie Acetaldehyd oder Furfurylaldehyd verwendet werden. Gewünschtenfalls können auch Mischungen der Phenol-Aldehydharze eingesetzt werden.

Die bevorzugt verwendeten Resole sind Kondensationsprodukte von Phenol, p-Chlorphenol, Resorcin oder o-, m- oder p-Kresol mit Formaldehyd.

Vorzugsweise setzt man der erfindungsgemäßen Mischung vor der Photopolymerisation einen Sensibilisator zu, wodurch die Härtungsgeschwindigkeit heraufgesetzt wird und es möglich ist, die Bestrahlungsdauer zu verkürzen oder eine weniger starke Strahlungsquelle zu verwenden. Weiterhin wird die Empfindlichkeit gegenüber sichtbarem Licht erhöht. Als Sensibilisatoren haben sich besonders aromatische polycyclische Verbindungen, die wenigstens drei kondensierte Ringe enthalten und eine Ionisationsenergie von weniger als etwa 7,5 eV aufweisen. Solche geeigneten Sensibilisatoren werden in der US-PS 4 069 054 beschrieben, wie beispielsweise Anthracen, Rubren,

Perylen, Phenanthren, Fluoranthene und Pyren. Vorzugsweise verwendet man 0,1 bis 2 Gewichts-%, insbesondere 0,25 bis 0,75 Gewichts-%, bezogen auf die Menge der Komponente a), am Sensibilisator.

Zur Photopolymerisation verwendet man aktinische Strahlen mit einer Wellenlänge von vorzugsweise 200 bis 600 nm. Geeignete Strahlenquellen für aktinische Strahlen sind Kohlelichtbögen, Quecksilberdampflampen, fluoreszierende Lampen, die UV-Licht aussenden, Argon- und Xenonglühlampen, Wolframlampen und photographisches Flutlicht. Von diesen sind am besten Quecksilberdampflampen und besonders Sonnenlampen und Metallhalogenlampen geeignet. Die Bestrahlungsdauer hängt von mehreren Faktoren ab, wie beispielsweise von der polymerisierbaren Substanz selbst, der Bestrahlungsquelle und ihrer Distanz zum zu bestrahlenden Material. Die geeignete Zeit kann vom Fachmann schnell ermittelt werden. Falls es notwendig ist, daß das photopolymerisierte Produkt noch mit dem beigemischten Heißhärtungsmittel härtbar sein soll, dann ist die Bestrahlung unterhalb der Härtungstemperatur mit dem Heißhärtungsmittel durchzuführen.

Wenn die erfindungsgemäße Mischung allein durch Hitze polymerisiert werden soll, werden vorzugsweise Temperaturen von 100 bis 175°C während 3 bis 20 Minuten angewendet.

Die erfindungsgemäßen Mischungen können als Beschichtungsmittel eingesetzt werden. Sie können auf Substrate, vorzugsweise als Flüssigkeit, appliziert werden, wie Stahl, Aluminium, Kupfer, Cadmium, Zink, Papier oder Holz und dann polymerisiert werden. Die erfindungsgemäßen Mischungen eignen sich auch zur Herstellung von Druckplatten oder gedruckten Schaltungen, indem man die Beschichtungen durch eine Maske bzw. Schablone bestrahlt und die unbestrahlten Teile der Beschichtungen mit einem Lösungsmittel entfernt. Methoden zur Herstellung von Druckplatten und gedruckten Schaltungen sind seit langem bekannt und werden z. B. im GB-Patent 1 495 746 beschrieben.

Die erfindungsgemäßen Mischungen können ferner als Klebemittel, zur Herstellung von Filmen bzw. Folien, als Preßmassen und zur Herstellung von faserverstärkten Verbandstoffen verwendet werden. Zusätzlich zu den faserverstärkten Materialien können auch noch andere Typen von Verstärkungsmitteln, wie Metallfolien, Kunststoffolien oder Folien aus Gummi eingesetzt werden.

Dabei wird die polymerisierbare Mischung vorzugsweise so angewendet, daß der erhaltene Verbandstoff aus 20 bis 80 Gewichts-% des Harzes und 80 bis 20 Gewichts-% aus den Verstärkungsmitteln besteht. Insbesondere besteht der Verbandstoff aus 30 bis 50 Gewichts-% Harz.

Es wurde ferner gefunden, daß es bei Verwendung von Aryloxysulphoxoniumsalzen möglich ist, das Epoxidharz oder das Phenoplast in zwei Stufen zu härten. Dabei wird das Harz in Gegenwart eines Aryloxysulphoxoniumsalzes und eines latenten, hitzeaktivierbaren Vernetzungsmittels für Epoxidharze oder Phenoplasten mittels aktinischer Bestrahlung in ein teilvernetztes B-Stufenharz überführt, welches dann durch Erhitzen vollständig ausgehärtet werden kann. So kann eine flüssige oder halbfeste Mischung zum Imprägnieren von Substraten verwendet werden, die beim Bestrahlen sich verfestigt. Zur endgültigen Aushärtung des Harzes kann der verfestigte Formstoff dann gewünschtenfalls erhitzt werden.

Gegenstand der vorliegenden Erfindung sind somit Mischungen, enthaltend ein Epoxidharz oder Phenoplast, ein Aryloxysulphoxoniumsalz in einer für die Polymerisation des Epoxidharzes oder Phenoplastes mittels aktinischen Strahlen wirksamer Menge und ein latentes Heißhärtungsmittel für das Epoxidharz oder Phenoplast in ausreichender Menge.

Geeignete hitzeaktivierbare Vernetzungsmittel für die Epoxidharzmischung sind Polycarbonsäureanhydride, Komplexe von Aminen, insbesondere primäre oder tertiäre aliphatische Amine, wie Äthylamin, Trimethylamin oder n-Octyldimethylamin, mit Bortrifluorid oder Bortrichlorid, ferner latente Bordifluorchelate. Aromatische Polyamine und Imidazole sind gewöhnlich nicht bevorzugt, weil sie zu mittelmäßigen Resultaten führen, was möglicherweise auf eine Reaktion zwischen freigesetzten Säurekatalysator und dem Amin beruht. Dicyandiamid kann erfolgreich angewendet werden, vorausgesetzt, daß relativ grobkörnige Partikel eingesetzt werden.

Geeignete hitzeaktivierbare Vernetzungsmittel für Resole sind beispielsweise Hexamethylentetramin und Paraformaldehyd.

Die Temperatur und die Dauer der Erhitzung, die für die thermische Härtung nach der Polymerisation der Harze erforderlich sind, sowie die Mengen der hitzeaktivierbaren Härtungsmittel können experimentell schnell vermittelt werden und läßt sich leicht aus den Erfahrungen über die Heißhärtung von Epoxidharzen und Phenol-Aldehydharzen ableiten.

Harze, welche nach der Photopolymerisation noch Epoxidgruppen oder phenolische Hydroxylgruppen aufweisen, durch welche sie heißgehärtet werden können, eignen sich insbesondere zur Herstellung von mehrlagigen gedruckten Schaltungen.

Eine weitere Anwendungsmöglichkeit für solche nach der Photopolymerisation noch hitzehärtbaren Harze besteht bei der Herstellung von Fadenwicklungen bzw. Heizwicklungen. Nach der Bestrahlung der harzimprägnierten Wicklung weist diese eine gewisse Flexibilität auf, so daß der Dorn bzw. Kern leichter aus der Wicklung entfernbar ist als wenn die Wirkung in einer Stufe gehärtet wird.

Aus den erfindungsgemäßen Mischungen lassen sich auch Klebefilme bzw. -bänder herstellen, indem man die Filme bis zur Verfestigung bestrahlt und die endgültige Vernetzung des Filmes beim Verkleben von Formstoffen vornimmt.

Die folgenden Beispiele beschreiben die Erfindung näher ohne sie einzuschränken. Wenn nichts

anderes angegeben ist, bedeuten Teile Gewichtsteile.

Die in den folgenden Beispielen verwendeten Aryloxysulphoxoniumsalze wurden nach dem von Chalkley et al. in »J. chem. Soc. (C)«, 1970, Seite 682—686, beschriebenen Verfahren hergestellt.

## Beispiel 1

Eine härtbare Mischung wurde nach Mischen von 50 Teilen 2,2-Bis-(4-glycidyloxyphenyl)-propan, 30 Teilen 3,4-Epoxycyclohexylmethyl-3,4-epoxycyclohexancarboxylat, 20 Teilen 1,4-Bis-(glycidyloxy)-butan und 2 Teilen Phenoxy-p-tolyl-p-tolyloxy-sulphoxoniumhexafluorophosphat hergestellt. Aus dieser Mischung wurde ein 10 µm dicker Film auf ein Zinnblech aufgezogen und der ultravioletten Strahlung ausgesetzt, indem der Film durch einen »Mini-cure«-Apparat (der Firma »Primarc Ltd.«, Stoke, England) gezogen wurde, welcher zwei Mitteldruck-Quecksilberbogenlampen (80 W pro cm) enthielt und mit einer Bandgeschwindigkeit von 30 Metern pro Minute arbeitet. Das Harz härtete zu einem harten, Lösungsmittel resistenten Film in weniger als 3 Sekunden, das heißt, der Film widerstand mehr als zwanzigmaliges Reiben mit einem in Aceton getränkten Baumwollappen.

## Beispiel 2

Ein Teil der härtbaren, in Beispiel 1 hergestellten Mischung wurde auf eine 1 mm dicke Glasplatte zu einem 10 µm dicken Film aufgetragen. Eine andere Glasplatte wurde darübergelegt und das Ganze wurde mit einer Niederdruck-Quecksilberbogenlampe (80 W pro cm) aus einer Entfernung von 8 cm bestrahlt. Nach einer Bestrahlungsdauer von 5 Sekunden waren beide Glasplatten dauerhaft miteinander verbunden.

## Beispiel 3

2 Teile Phenoxy-p-tolyl-p-tolyloxy-sulphoxoniumhexafluorophosphat wurden zu 100 Teilen 3,4-Dihydro-2H-pyran-2-ylmethyl-3,4-dihydro-2H-pyran-2-carboxylat zugegeben. Nach dem Durchmischen der Komponenten wurde die Mischung als 10 µm dicker Film auf Zinnblech aufgetragen. Nach einer Bestrahlungsdauer von 5 Sekunden mit einer Niederdruck-Quecksilberbogenlampe (80 W pro cm) aus einer Entfernung von 8 cm wurde ein harter, klebfreier Überzug erhalten.

## Beispiel 4

2 Teile Phenoxy-p-tolyl-p-tolyloxy-sulphoxoniumhexafluorophosphat wurden mit 100 Teilen eines im Handel erhältlichen Phenol-Formaldehyd-Resoles (Molverhältnis Phenol zu Formaldehyd = 1 : 1,6) gemischt. Analog Beispiel 3 wurde aus dieser Mischung ein 10 µm dicker Film hergestellt und bestrahlt. Nach 5 Sekunden erhielt man einen harten, klaren Film.

## Beispiel 5

2 Teile Phenoxy-p-tolyl-p-tolyloxy-sulphoxoniumhexafluorophosphat wurden mit 100 Teilen eines im Handel erhältlichen, hochkondensierten Harnstoff-Formaldehydharzes (Molverhältnis Harnstoff zu Formaldehyd = 1 : 1,4) gemischt. Die Mischung wurde wie in Beispiel 3 als 10 µm dicker Film aufgetragen und bestrahlt. Nach 5 Sekunden erhielt man einen klebfreien Überzug. Wenn man das Sulphoxoniumsalz fortläßt, bleibt das Harz nach der Bestrahlung klebrig und kann leicht durch Abwischen oder mit Wasser entfernt werden.

## Beispiel 6

Ein Teil der aus 2 Teilen Phenoxy-p-tolyl-p-tolyloxysulphoxoniumhexafluorophosphat und 100 Teilen 2,2-Bis-(4-glycidyloxyphenyl)-propan bestehenden Mischung wurde als 10 µm dicker Film auf Zinnblech appliziert. Diese Schicht wurde mit einer Hochdruck-Halogenmetallquarzlampe (400 W), welche vorwiegend Strahlen im Bereich von 365 nm aussendet, aus einer Distanz von 22 cm bestrahlt. Nach 5 Minuten Bestrahlungsdauer wurde ein leicht klebriger Film erhalten, der nach 5 Minuten Stehenlassen klebfrei wurde. Zu einem anderen Teil der Mischung wurde 5 Gewichts-% Pyren zugegeben. Die Bestrahlung des daraus hergestellten 10 µm dicken Filmes unter den Bestrahlungsbedingungen der zuvor bestrahlten Pyren-freien Mischung ergab eine klebfreie Beschichtung nach 45 Sekunden Bestrahlungsdauer. Dieser Film konnte mit Aceton nicht entfernt werden.

Beispiel 7

Unter den in Beispiel 2 angegebenen Bedingungen wurde ein 10 µm dicker Film aus einer Mischung von 2 Teilen 1-Phenoxy-1-oxidotetrahydrothiopheniumhexafluorophosphat und 100 Teilen 2,2-Bis-(4-Glycidyloxyphenyl)-propan bestrahlt. Nach 20 Sekunden Bestrahlungsdauer wurde eine klebfreie Beschichtung erhalten.

Beispiel 8

Beispiel 7 wurde wiederholt, wobei anstelle des Hexaflurophosphates 2 g 1-Phenoxy-1-oxidotetrahydrothiopheniumtetrafluoroborat eingesetzt wurden. Eine klebfreie Beschichtung wurde nach einer Bestrahlungsdauer von 1 Minute erhalten.

Beispiel 9

1 Teil p-Chlorophenoxy-p-tolylphenoxy-sulphoxoniumhexafluorophosphat wurde in 100 Teilen 3,4-Epoxycyclohexylmethyl-3,4-epoxycyclohexancarboxylat zugegeben und gemischt. Die Bestrahlung des daraus hergestellten 10 µm dicken Filmes unter den in Beispiel 2 angegebenen Bedingungen ergab einen harten, lösungsmittelbeständigen Film nach 1 Sekunde Bestrahlungsdauer.

Beispiel 10

Ein aus einer Mischung, enthaltend 1 Teil Phenyldiphenoxysulfphoxoniumhexafluorophosphat und 100 Teile 2,2-Bis-(4-glycidyloxyphenyl)-propan, bestehender 10 µm dicker Film wurde unter den in Beispiel 2 angegebenen Bedingungen bestrahlt. Nach 1 Sekunde Bestrahlungsdauer wurde ein harter, lösungsmittelbeständiger Film erhalten.

Beispiel 11

1 Teil Methyldiphenoxysulphoxoniumhexafluorophosphat wurde mit 100 Teilen 2,2-Bis-(4-glycidyloxyphenyl)-propan gemischt. Diese Mischung wurde unter den in Beispiel 2 angegebenen Bedingungen appliziert und bestrahlt. Nach 5 Sekunden Bestrahlungsdauer wurde eine völlig gehärtete Beschichtung erhalten.

Beispiel 12

Beispiel 11 wurde wiederholt unter Verwendung von 1 Teil Diphenylphenoxysulphoxoniumhexafluorophosphat anstelle des Methyldiphenoxysulphoxoniumsalzes. Es wurde ein harter, gehärteter, klebender Film nach 10 Sekunden Bestrahlungsdauer erhalten.

Beispiel 13

Gemäß der in Beispiel 2 angewendeten Arbeitsweise wurde eine 10 µm dicke Beschichtung aus einer aus 2 Teilen 1-Phenoxy-1-oxidotetrahydrothiophenium-hexafluoroantimonat und 100 Teilen 2,2-Bis-(4-glycidyloxyphenyl) bestehenden Mischung bestrahlt. Nach 10 Sekunden Bestrahlungszeit wurde eine klebfreie Beschichtung erhalten.

Beispiel 14

Die in Beispiel 1 angegebene Arbeitsweise wurde wiederholt, wobei der »Mini-Cure«-Apparat so eingestellt wurde, daß er eine Bandgeschwindigkeit von 90 Metern pro Minute aufwies. Innerhalb von 19 Sekunden härtete das Harz zu einer harten, lösungsmittelbeständigen Beschichtung.

In einem anderen Teil der obigen Mischung wurde 0,5 Gewichts-% Pyren zugegeben. Die unter gleichen Bestrahlungsbedingungen bestrahlte Beschichtung war bereits nach 10 Sekunden klebfrei.

## Beispiel 15

Eine flüssige Mischung wurde durch Mischen von 75 Teilen 2,2-Bis-(4-glycidyloxyphenyl)propan, 25 Teilen eines Polyglycidyläthers eines Phenol-Formaldehyd-Novolakes mit einem Epoxidgehalt von 5,6 Äquivalenten/kg, 4 Teilen Bortrichloridkomplex von n-Octyldimethylamin und 2 Teilen d-Chlorphenoxy-p-tolylphenoxysulphoxoniumhexafluorophosphat hergestellt. Diese härtbare Mischung wurde zur Herstellung eines Prepregs verwendet, indem man quadratische Glas-Gewebestücke mit diesem Harz imprägniert und beide Seiten der imprägnierten Glasgewebe mit einer Mitteldruck-Quecksilberbogenlampe (80 W pro cm) während 5 Sekunden aus einer Distanz von 8 cm bestrahlt. Ein 6-Lagen-Glasgewebelaminat wurde hergestellt durch Verpressen von sechs 10 $cm^2$ großen Stücken während 1 Stunde bei 120°C und einem Druck von 2,1 $MN/m^2$. Dieses aus 58 Gewichts-% Glas bestehende Laminat hatte eine interlaminare Schubfestigkeit von 448 $MN/m^2$.

## Beispiel 16

Es wurde eine Lösung hergestellt aus 1 g eines Diglycidyläthers von 2,2-Bis-(p-hydroxyphenyl)propan (Epoxidgehalt: 5,3 Äquivalente/kg), 4 g Tetraglycidyläther des 1,1,2,2-Tetra-(p-hydroxyphenyl)-äthans (Epoxidgehalt: 5,2 Äquivalente/kg), 5 g eines Diglycidyläthers von 2,2-Bis-(p-hydroxyphenyl)-propan, der mit einem bromhaltigen Phenol vorverlängert war und einen Erweichungspunkt von 50°C und einen Epoxidgehalt von 2 Äquivalenten/kg aufwies, und 0,1 g p-Chlorophenoxy-p-tolylphenoxysulphoxoniumhexafluorophosphat in 10 g Cyclohexanon. Eine Kupferplatte wurde mit dieser Lösung beschichtet und dann das Lösungsmittel verdampft, wobei ein etwa 10 µm dicker Film zurück blieb. Dieser Film wurde während 10 Minuten durch ein Negativ mit einer Mitteldruck-Quecksilberdampflampe (500 W) aus einer Distanz von 22 cm bestrahlt. Nach der Bestrahlung wurde das Bild in Toluol entwickelt, wobei die nicht belichteten Teile ausgewaschen wurden und ein gutes Reliefbild auf dem Kupfer zurückblieb. Die nicht beschichteten Kupferteile wurden dann mit einer 41% wäßrigen $FeCl_3$-Lösung geätzt, wobei die beschichteten Teile nicht angegriffen wurden.

## Beispiel 17

Eine Mischung aus 100 Teilen 3,4-Epoxycyclohexylmethyl-3,4-epoxycyclohexancarboxylat, 100 Teilen eines im Handel erhältlichen Copolymers aus Styrol und Allylalkohol mit einem Hydroxylgehalt von 3,56 Äquivalenten/kg (»RJ100« von der MONSANTO) und 2 Teilen p-Chlorphenoxy-p-tolylphenoxysulphoxoniumhexafluorophosphat wurde als eine 10 µm dicke Beschichtung auf ein Zinnblech appliziert und anschließend mit einer Mitteldruck-Quecksilberbogenlampe (80 W pro cm) bestrahlt. Nach 2 Sekunden bildete sich eine klebfreie, flexible Beschichtung.

## Beispiel 18

In diesem Beispiel wird die Wirksamkeit der erfindungsgemäßen Katalysatoren mit den vorbekannten Katalysatoren bezüglich ihrer Eignung für die Photopolymerisation verglichen.

Mischungen wurden hergestellt aus 2 Teilen des Katalysators, 50 Teilen von 2,2-Bis(4-glycidyloxyphenyl)-propan, 30 Teilen 3,4-Epoxycyclohexylmethyl-3,4-epoxycyclohexancarboxylat und 20 Teilen 1,4-Diglycidyloxybutan. 10 µm dicke Filme wurden auf Zinnbleche aufgezogen und der UV-Bestrahlung ausgesetzt, indem diese zweimal durch den in Beispiel 1 beschriebenen »Mini-cure«-Apparat mit einer Transportbandgeschwindigkeit von 60 Metern pro Minute durchgelassen wurden. Die Bestrahlungsdauer, die erforderlich war, um die Beschichtungen klebfrei zu machen, ist in der folgenden Tabelle angegeben.

| Mischung | Katalysator | Zeit bis zum Aufhören der Klebrigkeit (Sekunden) |
|---|---|---|
| a | Phenoxy-p-tolyl-p-tolyloxy-sulphoxoniumhexafluorophosphat | 7 |
| b | Phenyldiphenoxysulphoxonium-hexafluorophosphat | 13 |
| c | Triphenylsulphoniumhexafluorophosphat | 42 |
| d | 3,3'-Dinitrodiphenyljodonium-hexafluorophosphat | 45 |

Triphenylsulphoniumhexafluorophosphat wurde bereits kommerziell für die Photopolymerisation von Epoxidharzen angewendet. Jodiumsalze werden in der Patentliteratur als geeignete Katalysatoren für die Photopolymerisation von Epoxidharzen beschrieben. Aus dem Vergleich kann der Vorteil bei der erfindungsgemäßen Verwendung der Sulphoxoniumsalze als Katalysatoren für die Photopolymerisation von Epoxidharzen entnommen werden.

Beispiel 19

2 Teile 1-Phenoxy-1-oxidotetrahydrothiopheniumhexafluorophosphat wurden mit 98 Teilen 2,2-Bis-(4-glycidyloxyphenyl)-propan vermahlen. 15 g dieser Mischung wurde während 24 Stunden auf 60° C erhitzt, wobei das Harz flüssig blieb und nicht gelierte. Zwei weitere Proben von je 15 g der obigen Mischung wurden auf 110° C bzw. 150° C erhitzt, wobei diese in 17 bzw. 6 Minuten härteten. Aus diesem Versuch geht hervor, daß die erfindungsgemäßen Mischungen bei Raumtemperatur eine lange Lagerstabilität aufweisen, durch Erhitzen auf erhöhte Temperatur jedoch schnell ausgehärtet werden können.

Beispiel 20

Eine Mischung aus 2 Teilen Phenyldiphenoxysulphoxoniumhexafluorophosphat und 98 Teilen 3,4-Epoxycyclohexylmethyl-3,4-epoxycyclohexancarboxylat wurde als 10 μm dicker Film auf Zinnblech appliziert und während 15 Minuten auf 120° C erhitzt. Es wurde ein harter, klebfreier Überzug erhalten.

Beispiel 21

Eine Mischung aus 2 Teilen 1-Phenoxy-1-oxidotetrahydrothiopheniumhexafluorophosphat und 98 Teilen des in Beispiel 4 verwendeten Phenol-Formaldehyd-Resols wurde als 10 μm dicker Film auf Zinnblech aufgetragen und während 15 Minuten auf 110° C erhitzt. Der erhaltene Überzug war hart und beständig gegenüber Aceton.

**Patentansprüche**

1. Mischung, enthaltend
a) eine Verbindung oder Mischungen von Verbindungen, welche unter dem Einfluß von kationischen Katalysatoren in höhermolekulare Produkte umwandelbar sind und
b) eine wirksame Menge eines Aryloxysulphoxoniumsalzes der Formel VI

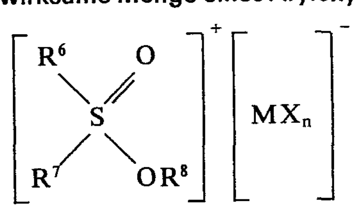

(VI)

worin

$R^6$ und $R^7$ je ein unsubstituiertes oder gegebenenfalls durch ein oder zwei Halogenatome substituiertes oder durch ein Äthersauerstoffatom oder eine Sulfonylgruppe unterbrochenes Alkyl mit 1 bis 6 C-Atomen, ein Aryl mit 6 bis 15 C-Atomen, eine Alkoxygruppe mit 6 bis 15 C-Atomen oder $R^6$ und $R^7$ zusammen einen zweiwertigen Rest mit 4 bis 10 C-Atomen bedeuten,

$R^8$ ein Aryl mit 6 bis 15 C-Atomen bedeutet,

M für ein Metall- oder Nichtmetallatom steht,

X' ein Halogenatom, vorzugsweise Fluor- oder Chloratom, bedeutet, und

n für die Zahl 4, 5 oder 6 steht, wobei diese Zahl um eins größer ist, als die Wertigkeit von M beträgt.

2. Mischung gemäß Anspruch 1, worin $R^6$ und $R^7$ je ein Aryl oder Aryloxy mit 6 bis 11 C-Atomen bedeutet.

3. Mischung gemäß Anspruch 1, worin $R^6$ und $R^7$ zusammen einen Alkylenrest bedeuten.

4. Mischung gemäß Anspruch 1, worin $R^8$ ein unsubstituiertes oder gegebenenfalls durch ein oder zwei Alkyle oder Alkoxy mit 1 bis 4 C-Atomen, ein oder zwei Nitrogruppen, Fluor-, Chlor- oder Bromatome substituiertes Phenyl oder Naphthyl bedeutet.

5. Mischung gemäß Anspruch 1, worin M ein Bor-, Phophor-, Arsen-, Antimon- oder Wismutatom und X ein Fluor- oder Chloratom bedeuten.

6. Mischung gemäß Anspruch 1, worin die Komponente b) ein
Diphenylphenoxysulfoxoniumhexafluorophosphat,
phenyldiphenoxysulfoxoniumhexafluorophosphat,
Methyldiphenoxysulfoxoniumhexafluorophosphat,
p-Tolylphenoxy-p-tolyloxysulfoxoniumhexafluorophosphat,
Äthyl-(äthylsulfonylmethyl)-p-tolyloxysulfoxoniumhexafluorophosphat,
p-Chlorophenoxy-p-tolylphenoxysulfoxoniumhexafluorophosphate,
1-Phenoxy-1-oxidotetrahydrothiopheniumhexafluorophosphate,
1-Phenoxy-1-oxidotetrahydrothiopheniumtetrafluoroborat oder
1-Phenoxy-1-oxidotetrahydrothiopheniumhexafluoroantimonat
ist.

7. Mischung gemäß Anspruch 1, worin die Komponente a) ein 1,2-Epoxid, ein Vinylmonomer oder -präpolymer, ein Aminoplast oder Phenoplast ist.

8. Mischung gemäß Anspruch 1, worin die Komponente a) ein Epoxidharz oder ein aus Phenol und einem Aldehyd hergestelltes Resolharz ist.

9. Mischung gemäß Anspruch 1, enthaltend 0,1 bis 7,5 Gewichtsteile der Komponente b) pro 100 Gewichtsteile der Komponente a).

10. Mischung gemäß Anspruch 8, enthaltend zusätzlich ein latentes Heißhärtungsmittel für das Epoxidharz oder für das Resolharz.

11. Verfahren zur Herstellung von höhermolekularen Produkten aus Mischungen gemäß Anspruch 1, dadurch gekennzeichnet, daß man diese Mischung mit aktinischen Strahlen bestrahlt oder erhitzt.

## Claims

1. A composition comprising

a) a compound, or mixture of compounds, capable of being transformed into a higher-molecular weight material under the influence of a cationic catalyst,

b) an effective amount of an aryloxysulphoxonium salt of the formula

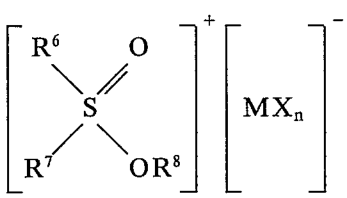

(VI)

wherein each of

$R^6$ and $R^7$ denotes an alkyl group of 1 to 6 carbon atoms which is unsubstituted or substituted by a halogen atom or interrupted in the chain by an ether oxygen atom or a sulphonyl group, or is an aryl group of 6 to 15 carbon atoms or an alkoxy group of 6 to 15 carbon atoms, or $R^6$ and $R^7$ together are a divalent radical of 4 to 10 carbon atoms, $R^8$ is an aryl group of 6 to 15 carbon atoms,

M is an atom of a metal or non-metal,

X is a halogen atom, preferably a fluorine or chlorine atom, and

n is 4, 5, or 6 and is one more than the valency of M.

2. A composition according to claim 1, wherein each of $R^6$ and $R^7$ is an aryl or aryloxy group of 6 to 11 carbon atoms.

3. A composition according to claim 1, wherein $R^6$ and $R^7$ together are an alkylene radical.

4. A composition according to claim 1, wherein $R^8$ is a phenyl or naphthyl group, unsubstituted or substituted by one or two alkyl or alkoxy groups of 1 to 4 carbon atoms each, by one or two nitro groups, or by one or two fluorine, chlorine, or bromine atoms.

5. A composition according to claim 1, wherein M is an atom of boron, phosphorus, arsenic, antimony, or bismuth, and X is a fluorine or chlorine atom.

6. A composition according to claim 1, wherein component b) is
a diphenylphenoxysulfoxonium hexafluorophosphate,
a phenyldiphenoxysulfoxonium hexafluorophosphate,
a methyldiphenoxysulfoxonium hexafluorophosphate,
a p-tolylphenoxy-p-tolyloxysulfoxonium hexafluorophosphate,
an ethyl (ethylsulfonylmethyl)-p-tolyloxysulfoxonium hexafluorophosphate,
a p-chlorophenoxy-p-tolylphenoxysulfoxonium hexafluorophosphate,
a 1-phenoxy-1-oxidotetrahydrothiophenium hexafluorophosphate,
a 1-phenoxy-1-oxidotetrahydrothiophenium tetrafluoroborate or
a 1-phenoxy-1-oxidotetrahydrothiophenium hexafluoroantimonate.

7. A composition according to claim 1, wherein component a) is a 1,2-epoxide, a vinyl monomer or prepolymer, an aminoplast, or a phenoplast.

8. A composition according to claim 1, wherein component a) is an epoxide resin or a resol resin made from a phenol and an aldehyde.

9. A composition according to claim 1, containing 0.1 to 7.5 parts by weight of component b) per 100 parts by weight of component a).

10. A composition according to claim 8, which also contains a latent heat-curing agent for the epoxide resin or for the resol resin.

11. A process for the production of higher molecular weight products obtained from a composition as claimed in claim 1, which process comprises subjecting said composition to actinic radiation or heating it.

**Revendications**

1. Mélange comprenant

a) un composé ou un mélange de composés convertibles en produits à haute masse moléculaire en présence de catalyseurs cationniques et

b) une proportion efficace d'un sel d'aryloxysulfoxonium de formule VI

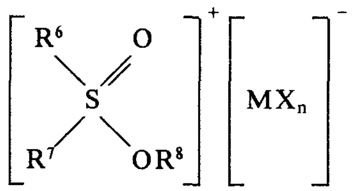

(VI)

dans laquelle

$R^6$ et $R^7$ représentent chacun un alkyle en $C_1$ à $C_6$, sans substituants ou portant in ou deux atomes d'halogène ou éventuellement interrompu par un atome d'oxygène en groupe éther ou par un groupe sulfonyle, un aryle en $C_6$ à $C_{15}$ ou un groupe alcoxy en $C_6$ à $C_{15}$, ou bien $R^6$ et $R^7$ représentent ensemble un radical divalent en $C_4$ à $C_{10}$,

$R^8$ est un aryle en $C_6$ à $C_{15}$,

M un atome de métal ou de métalloïde,

X un atome d'halogène, de préférence de fluore ou de chlore, et

n est le nombre 4, 5 ou 6, nombre supérieur de 1 à la valence de M.

2. Mélange selon la revendication 1 dans lequel, dans le sel de formule VI, $R^6$ et $R^7$ sont chacun un groupe aryle ou aryloxy en $C_6$ à $C_{11}$.

3. Mélange selon la revendication 1 dans lequel $R^6$ et $R^7$ forment ensemble un radical alkylène.

4. Mélange selon la revendication 1 dans lequel $R^8$ est un phényle ou un naphthyle sans substituants ou portant un ou deux alkyles ou alcoxy en $C_1$ à $C_4$ un ou deux groupes nitro, ou atomes de fluore, de chlore ou de brome.

5. Mélange selon la revendication 1 dans lequel M est un atome de bore, de phosphore, d'arsenic, d'antimoine ou de bismuth et X un atome de fluore ou de chlore.

6. Mélange selon la revendication 1 dans lequel la composante b) est
l'hexafluorophosphate de diphénylphénoxysulfoxonium,
l'hexafluorophosphate de phényldiphénoxysulfoxonium,
l'hexafluorophosphate de méthyldiphénoxysulfoxonium,
l'hexafluorophosphate de p-tolylphénoxy-p-tolyloxysulfoxonium,
l'hexafluorophosphate d'éthyl-(éthylsulfonylméthyl)-p-tolyloxysulfoxonium,
l'hexafluorophosphate de p-chlorophénoxy-p-tolylphénoxysulfoxonium,
l'hexafluorophosphate de 1-phénoxy-1-oxidotétréhydrothiophénium,
l'le tétrafluoroborate de 1-phénoxy-1-oxidotétrahydrothiophénium ou
l'hexafluoroantimonate de 1-phénoxy-1-oxido-tétrahydrothiophénium.

7. Mélange selon la revendication 1 dans lequel la composante a) est un 1,2-époxyde, un monomère ou un prépolymère vinylique, un aminoplaste ou un phénoplaste.

8. Mélange selon la revendication 1 dans lequel la composante a) est une résine époxyde ou un résol d'un phénol et d'un aldéhyde.

9. Mélange selon la revendication 1 contenant 0,1 à 7,5 parties en poids de la composante b) pour 100 parties en poids de la composante a).

10. Mélange selon la revendication 8 contenant en outre un thermodurcisseur latent pour la résine époxyde ou pour le résol.

11. Procédé de fabrication de produits macromoléculaires à partir de mélanges selon l'une quelconque des revendications précédentes, procédé caractérisé en ce que l'on chauffe le mélange ou bien on le soumet à une irradiation actinique.